# FASCICULE DE BREVET EUROPEEN

(11) **EP 0 666 537 B1**
(45) Date de publication et mention de la délivrance du brevet: **17.03.1999**
(21) Numéro de dépôt: 95400162.4
(22) Date de dépôt: 25.01.1995
(51) Int. Cl.: G06F 11/26, G01R 31/28

(54) **Circuit de traitement numérique comportant des registres de test**
Digitale Verarbeitungsschaltung mit Prüfregistern
Digital processing circuit with test registers

(30) Priorité: 04.02.1994 FR 9401302
(43) Date de publication de la demande: 09.08.1995
(73) Titulaire: STMicroelectronics S.A., 94253 Gentilly Cédex (FR)
(72) Inventeur: Colavin, Oswald, F-38340 Voreppe (FR)
(74) Mandataire: Michelet, Alain

(56) Documents cités:
- EP-A- 0 358 376
- US-A- 4 701 921

## Description

L'invention concerne un circuit de traitement numérique comportant des registres de test.

Elle concerne plus particulièrement un circuit numérique muni d'une interface hôte permettant l'accès de son bus à un système d'informatique externe.

L'utilisation de registres de test est classique dans les circuits de traitement numérique, ils permettent de contrôler le fonctionnement du circuit et en particulier de certains blocs, aussi bien lors du développement que lors des contrôles de fabrication desdits circuits.

Jusqu'à présent, ces circuits permettent essentiellement l'accès aux données de fonctionnement du circuit et l'accès aux différents registres, indépendamment les uns des autres, n'est pas possible.

Par ailleurs, ces registres de test connus ne permettent pas d'alimenter n'importe quel bloc avec des données prédéterminées en fonction des tests que l'on souhaite réaliser.

Les techniques de transmission et le stockage d'images numérisées permettent d'améliorer de manière significative la qualité des images finalement obtenues par rapport à la transmission analogique. Il est ainsi possible de multiplier également les applications de ces techniques.

Toutefois, la transmission directe et le stockage d'images numérisées animées nécessite un flux d'informations extrêmement élevé, ce qui rend nécessaire, en pratique, la compression et le codage de ces images.

Ainsi, les images numérisées sont codées avant transmission, de manière à diminuer la quantité d'informations les représentant, puis décodées après transmission.

Les techniques de codage et décodage sont bien entendu essentielles pour la qualité des images finalement obtenues et il est apparu nécessaire, pour assurer la compatibilité des différents matériels mettant en oeuvre ces techniques, d'en assurer une normalisation.

C'est ainsi qu'un groupe d'Experts (Moving Picture Expert Group - MPEG) a mis au point la norme ISO 11172.

Cette norme souvent désignée par le sigle MPEG définit des conditions de codage et de décodage d'images animées, éventuellement associées à un signal sonore, pouvant être utilisées aussi bien pour la mise en mémoire et la restitution d'images que pour leur transmission.

Cette norme MPEG peut donc être utilisée pour le stockage d'images sur des compact discs, compact discs interactifs, sur des bandes magnétiques, être utilisée pour la transmission d'images au travers de réseaux locaux, de lignes téléphoniques comme pour la transmission d'images télévision par voie hertzienne.

La norme définissant de manière complète et détaillée l'ensemble de cette technique est accessible auprès des organismes de normalisation et il convient de s'y référer pour accéder à sa description détaillée.

La compression de données mise en oeuvre selon la norme MPEG peut suivre plusieurs traitements.

Les images consécutives sont tout d'abord collectées, de manière à former un groupe d'images formant une séquence. Une séquence est donc subdivisée en groupes d'images.

Chaque image est divisée en tranches, chaque tranche étant elle-même décomposée en macro-blocs qui constituent l'élément de base utilisé pour appliquer une compensation de mouvements et pour changer, éventuellement, l'échelle de quantification.

Les macro-blocs sont formés d'une matrice 16 x 16 d'éléments d'image (pixels).

Chaque macro-bloc est divisé en six blocs, les quatre premiers portant une information de luminance et les deux autres portant une information de chrominance, respectivement bleue et rouge.

Chacun de ces six blocs est défini comme étant une matrice de 8 x 8 éléments d'images (pixels).

A l'intérieur de chaque séquence, différents types d'images sont définis, de manière à réduire la quantité d'informations à stocker ou à transmettre en raison des analogies existantes entre les informations contenues dans les différentes images d'une même séquence.

Les images I (Intra frames) sont des images codées comme une image immobile et donc sans référence à une autre image.

Les images P (Predicted) sont déduites à partir de l'image I ou P précédemment reconstruite.

Les images B (Bi-directional frames) sont déduites de deux images I et P ou P et P reconstruites, l'une juste avant et l'autre juste après.

Il faut souligner ici que, généralement, l'ordre de transmission des images d'une séquence ne correspond pas à leur ordre de présentation lors de l'acquisition ou de la restitution. Elles sont dans l'ordre de décodage.

La transformation discrète en cosinus (Discrete Cosine Transformation - DCT) est appliquée au niveau des blocs.

Cette transformation DCT transforme des blocs spatiaux, définis comme nous l'avons indiqué plus haut en une matrice 8 x 8 de pixels, en des blocs temporels formés d'une matrice également 8 x 8, de fréquences spatiales.

On a montré que dans la matrice 8 x 8 du bloc temporel, le coefficient de fonds continu (DC) placé en haut à gauche dans la matrice est beaucoup plus important, pour l'impression visuelle obtenue, que les autres composants correspondant à différentes fréquences.

Plus précisément, plus la fréquence est élevée, moins l'oeil y est sensible.

C'est la raison pour laquelle on quantifie les niveaux des fréquences, d'autant plus que les fréquences sont élevées. Cette quantification est assurée par un algorithme qui n'est pas imposé par la norme, qui peut être une opération de quantification et de codage à longueur variable (Variable Length Coding - VLC).

La matrice dans le domaine fréquentiel obtenue par la transformation DCT est ensuite traitée par une matrice dite "matrice de quantification" qui est utilisée pour diviser chacun des termes de la matrice du domaine temporel par une valeur dépendant de sa position et prenant en compte le fait que le poids des différentes fréquences représentées par ces coefficients est variable.

Le résultat de cette opération conduit, après que chacune des valeurs ait été arrondie à la valeur entière la plus proche, à un nombre important de coefficients égal à zéro.

Il faut souligner que, pour les macro-blocs intra, la valeur de quantification du coefficient de fond (DC) est constante, par exemple égale à 8. Les coefficients de fréquence non nuls sont alors codés selon un balayage en zigzag, par référence à une table de Huffman, donnant à chacun des coefficients de la matrice une valeur codée de longueur variable, et réduisant le volume d'information.

De préférence, les coefficients représentant le fonds continu sont transmis après quantification et, par ailleurs, la matrice de quantification est optimisée, de manière à ce que le volume d'informations soit inférieur à un niveau prédéterminé correspondant aux possibilités de stockage ou de transmission, sans que cela porte atteinte de manière excessive à la qualité de l'information transmise.

Les images de type I sont codées sans l'utilisation de vecteur de mouvement.

Au contraire, les images de type P et B utilisent, au moins pour certains des macro-blocs qui les composent, des vecteurs de mouvement permettant d'augmenter l'efficacité du codage et indiquant de quelle partie de la ou des images de référence, un macro-bloc particulier de l'image considérée doit être déduit.

La recherche du vecteur de mouvement fait l'objet d'une optimisation lors du codage et il est lui-même codé en utilisant la technique DPCM qui exploite au mieux la corrélation existante entre les vecteurs de mouvement des différents macro-blocs d'une même image. Ils font finalement l'objet d'un codage à longueur variable (VLC).

Toutes les informations concernant une séquence codée forment le flux d'informations numériques (bitstream) qui est soit enregistré, soit transmis.

Un tel flux d'informations numériques commence par un en-tête de séquence contenant un certain nombre d'informations et de paramètres dont les valeurs sont maintenues pour l'ensemble de la séquence.

De même, la séquence étant décomposée en groupes d'images, chacun de ces groupes est précédé par un en-tête de groupe et les données représentant chaque image sont elles-mêmes précédées d'un en-tête d'image.

La mise en oeuvre de registres de test est particulièrement importante dans des circuits complexes, tels que ceux mis en oeuvre pour le décodage des flux d'informations en vue de la reconstitution d'images, telles qu'envisagées selon la norme MPEG.

Le document US-4.701.921 décrit un système de test logique à balayage. Il comprend des modules logiques fonctionnels, chacun d'entre eux ayant une interface avec des bus de commande, d'adresse et d'entrée-sortie et avec des lignes de données de balayage. Chaque module comprend des circuits logiques et des circuits de verrouillage de registre à décalage (SRL) et de registre parallèle (PRL).

L'un des buts de l'invention est de permettre le test d'un bloc à l'intérieur d'un circuit de traitement numérique en choisissant les données d'entrées et en examinant les données de sorties de ce bloc.

C'est un autre objectif de la présente invention de permettre la réalisation de tests à l'aide de registres qui puissent être transparents lors de l'utilisation du système.

C'est encore un objectif de la présente invention de permettre l'utilisation de registres de tests dans le cadre de développement de circuits de décodage MPEG qui permettent de fixer des paramètres représentatifs de l'environnement de fonctionnement du système tels que, par exemple, la taille et les autres paramètres représentatifs d'une image.

L'invention concerne un circuit de traitement numérique tel que défini dans la revendication 1.
Des modes de réalisation préférés sont spécifiés dans les revendications dépendantes.

Dans d'autres modes de réalisation préférés, le dispositif de l'invention comporte les caractéristiques suivantes, prises selon toutes leurs combinaisons techniquement possibles :
- à l'état de repos, les registres de test sont transparents ;
- avant le début d'un cycle de lecture ou d'écriture, le bus de données est haute impédance ;
- il est compris dans une unité de décodage d'un flux de données représentant des images conformément à la norme MPEG ;
- un registre de test donné peut conserver l'état actif indéfiniment, tout en autorisant l'accès aux autres registres de test ;
- un registre de test au moins contient lui-même l'information de son état (actif ou repos) ;
- un registre de test peut être activé par un programme dans l'environnement applicatif, tout en préservant le comportement normal des blocs du circuit non concernés.

L'invention sera décrite plus en détail en référence aux dessins annexés, dans lesquels :
- la Figure 1 est une représentation schématique globale d'un circuit de traitement numérique selon l'invention ;

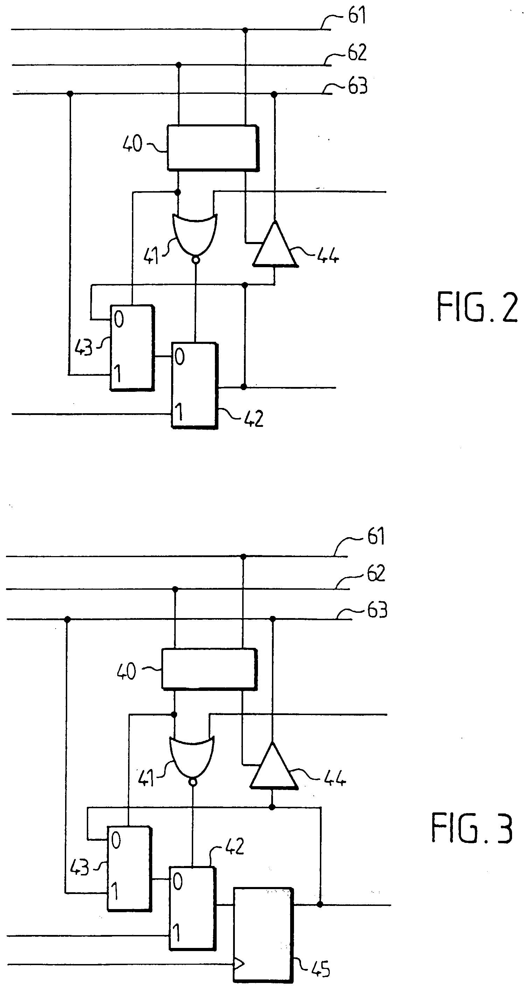

- la Figure 2 est une représentation schématique d'un premier mode de réalisation de l'invention ;
- la Figure 3 est une représentation schématique d'un deuxième mode de réalisation de l'invention ;
- la Figure 4 est une représentation schématique d'un troisième mode de réalisation de l'invention ;
- la Figure 5 est un chronogramme des opérations de lecture dans le deuxième mode de réalisation de l'invention ;
- la Figure 6 est un chronogramme des opérations d'écriture dans le deuxième mode de réalisation de l'invention ;
- la Figure 7 est une représentation des opérations d'écriture et de lecture des informations d'entrée et de sortie d'un même bloc selon le deuxième mode de réalisation de l'invention.

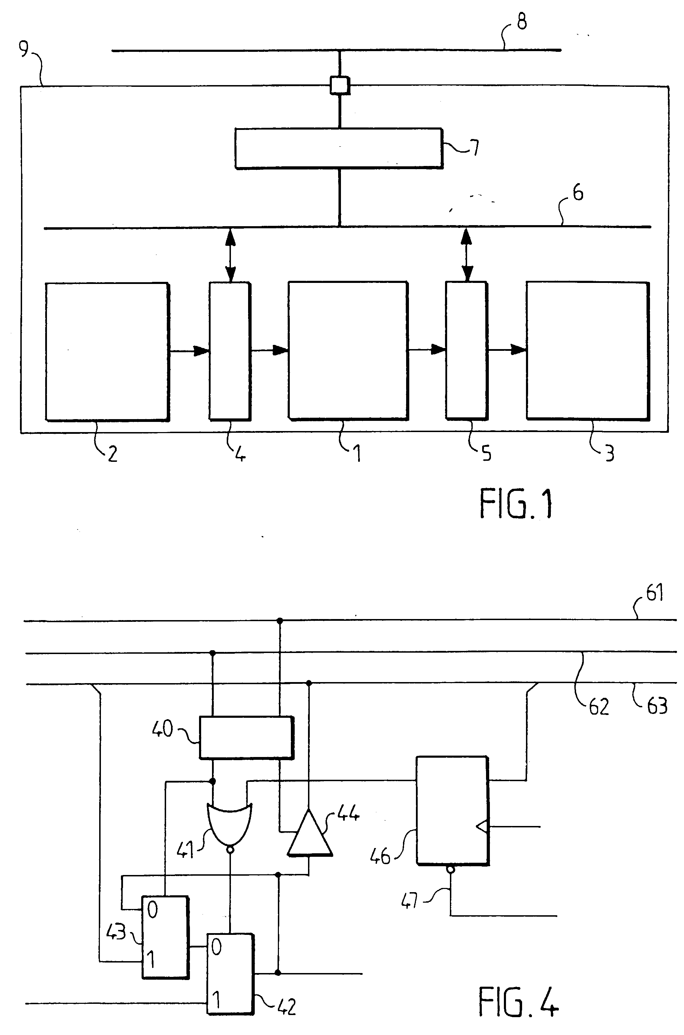

Le circuit 9 de traitement numérique, représenté sur la Figure 1, est décomposé en un bloc fonctionnel 1 précédé d'un bloc fonctionnel amont 2 et suivi d'un bloc fonctionnel aval 3. Un registre de test n, aussi appelé registre amont, est placé entre le bloc amont 2 et le bloc testé 1 et un registre n+1 5, aussi appelé registre aval, est placé entre le bloc testé 1 et le bloc aval 3.

Le bus 6 est muni d'une interface hôte 7 qui permet à un système informatique extérieur, représenté par son bus 8, d'adresser et de recevoir des informations par l'intermédiaire du bus 6.

De manière classique, le bus 6 comporte des lignes de contrôle 61, des lignes d'adresse 62 et des lignes de données 63.

Chaque registre de test 4, 5 comporte une unité de décodage 40 reliée en entrée aux lignes de contrôle 61 et d'adresse 62 et émettant, en fonction des signaux reçus de ces lignes, un signal d'écriture ou un signal de lecture. Un opérateur 41 reçoit, sur l'une de ses entrées, le signal d'écriture et, sur l'autre de ses entrées, un signal de commande provenant soit d'un registre de contrôle des tests, soit du registre testé lui-même et autorisant une opération d'écriture. La sortie de cet opérateur 41 est reliée à la commande d'un deuxième multiplexeur 42.

Ce deuxième multiplexeur 42 reçoit, lorsqu'il est un test de registre amont, sur son entrée, les données provenant du bloc amont, et sa sortie est reliée à l'entrée des données du bloc à tester 1. Bien entendu, lorsqu'il constitue un registre aval, le multiplexeur 42 reçoit, sur l'une de ses entrées, les données provenant du bloc à tester, et sa sortie est reliée à l'entrée des données du bloc aval.

Un premier multiplexeur 43 reçoit, sur l'une de ses entrées, les données provenant de la ligne de données 63 du bus 6 et la deuxième de ses entrées est reliée au signal de sortie du deuxième multiplexeur 42. Cette sortie est d'autre part reliée par l'intermédiaire d'une porte 44 actionnée par le signal de lecture émis par le décodeur 40 à la ligne de données 63 du bus 6.

Cette première description correspond exactement à un premier mode de réalisation.

Dans un deuxième mode de réalisation, une bascule D flip flop 45 est interposée entre le deuxième multiplexeur 42 et la sortie du registre de test communicant les données au bloc qui le suit. Dans ce dernier cas, la porte 44 est également reliée à la sortie de la bascule 45.

Ainsi, les signaux de contrôle et d'adresse circulant sur le bus 6 peuvent produire les opérations d'écriture et de lecture du registre.

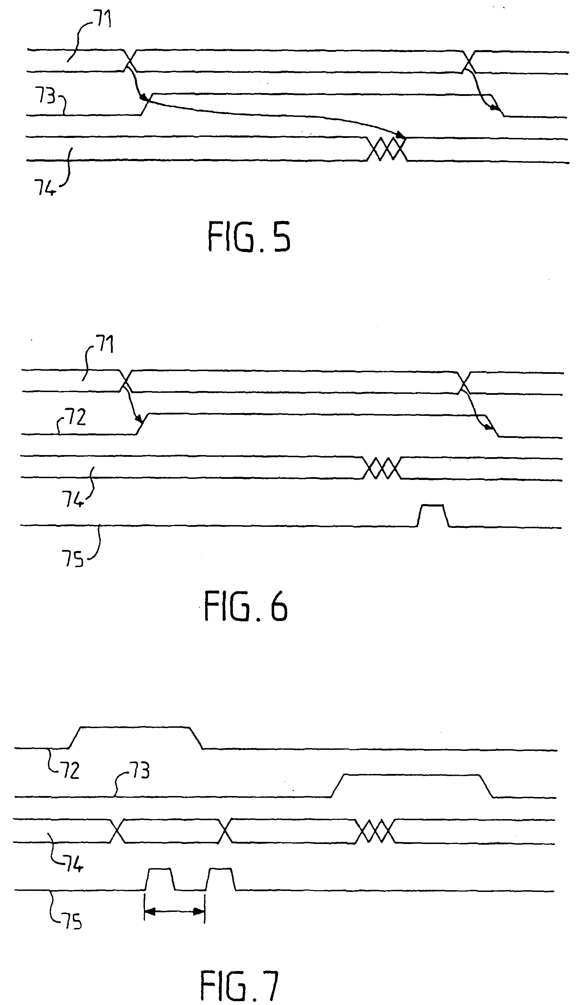

Un registre (4, 5) peut conserver l'état actif indéfiniment, tout en autorisant l'accès aux autres registres de test. Il contient avantageusement, selon le troisième mode de réalisation représenté sur la Figure 4, l'information de son état (actif ou repos), par exemple dans un registre à verrouillage 46, et peut être activé par un programme provenant du système informatique extérieur, c'est-à-dire de l'environnement applicatif, sans que cela affecte le comportement des autres blocs du circuit.

Le registre à verrouillage 46 conserve l'information de l'état du registre (4, 5), il est relié à l'une des entrées de l'opérateur 41 et à la ligne de données 63. Il comporte une entrée de remise à zéro 47 permettant sa remise à zéro par le signal de remise à zéro général du circuit.

Par ailleurs, un signal de contrôle qui peut être mis en mémoire dans un registre particulier, permet de rendre le registre transparent.

Sur les Figures 4 à 6 représentant des chronogrammes d'écriture et de lecture, les signaux d'adresse sont référencés 71, les signaux de commande d'écriture et de lecture sont respectivement référencés 72 et 73, les signaux de données sont référencés 74 et le signal d'horloge 75.

En se référant plus particulièrement au deuxième mode de réalisation, le fonctionnement des tests est le suivant :
- Lorsque le décodage des champs adresse et contrôle sur le bus 6 génère une commande d'écriture, les données sont reconnues et dûment acquises par le registre.

Le cycle de lecture est également suivi de la même manière lorsque le test est réalisé conformément au premier mode de réalisation de l'invention.
- Le cycle d'écriture commence lorsque le décodage des champs adresse et contrôle du bus interne génère une impulsion d'écriture. Pour le registre de test transparent, correspondant au premier mode de réalisation, les données sont échantillonnées lors de la retombée de la commande d'écriture. Pour le registre de test avec une bascule D flip flop, les données sont échantillonnées sur chaque flanc montant des impulsions d'horloge pendant que le signal d'écriture l'autorise.

Le deuxième type de registre dit "flip flop" permet la réalisation de tests à la vitesse nominale.

A cet effet, les données correspondant au test d'entrée sont écrites dans le registre amont et après que deux fronts montants d'impulsion d'horloge soient intervenus, le test de sortie est lu dans le registre aval.

En effet, le premier front montant a ainsi permis l'échantillonnage de la valeur de données pour le test d'entrée et le deuxième front d'horloge permet le même échantillonnage pour les données de sortie du registre de test aval.

La commande des signaux de lecture et d'écriture pour chacun des registres de test à l'aide du système informatique externe 8 par l'intermédiaire de l'interface hôte 7 permet le test rapide et complet de chacun des blocs du circuit numérique à tester.

On comprend que ces opérations rapides sont d'autant plus appréciées que les circuits concernés sont complexes.

Les signes de référence insérés après les caractéristiques techniques mentionnées dans les revendications, ont pour seul but de faciliter la compréhension de ces dernières, et n'en limitent aucunement la portée.

## Revendications

1. Circuit de traitement numérique (9) comportant une interface hôte (7) permettant l'accès de son bus (6) à un système informatique externe (8), ledit bus (6) comportant des lignes de contrôle, des lignes d'adresse et des lignes de données, ledit circuit étant décomposé en blocs (1, 2, 3), des registres de test (4, 5) étant interposés entre un bloc amont et un bloc aval, chacun des registres de test (4, 5) étant relié au bus ( 6), ayant un état actif et un état de repos, étant identifié par une adresse permettant de lui adresser des données ou de lire des données qu'il contient, et comportant des moyens permettant la génération de signaux de lecture ou d'écriture en fonction des signaux présents sur ces lignes le faisant passer à l'état actif, et des moyens complémentaires autorisant cette écriture ou cette lecture, et l'accès à chacun des registres de test étant indépendant des autres registres de test, caractérisé en ce que chaque registre de test comporte un premier multiplexeur (43) commandé par le signal d'écriture, recevant les données circulant sur le bus sur l'une de ses entrées et dont la sortie est reliée à un deuxième multiplexeur (42) commandé par la sortie d'un opérateur (41) ou recevant en entrée le signal d'écriture, et un signal d'autorisation d'écriture, dont la deuxième entrée est reliée au bloc amont et la sortie au bloc aval, en ce que chaque registre de test (4, 5) comporte une bascule D (45) placée entre les blocs (1, 2, 3), séparés par le registre lorsque celui-ci est à l'état de repos et en ce que le circuit de traitement permet des tests à la vitesse nominale de fonctionnement d'un bloc n, le test d'entrée étant inscrit dans le registre amont sur le front de montée d'une première impulsion d'horloge, et la lecture du registre aval étant effectuée sur le front de montée d'une deuxième impulsion d'horloge suivant immédiatement la première.

2. Circuit de traitement numérique selon la revendication 1, caractérisé en ce que chaque registre de test permet d'observer l'état de sortie du bloc amont et de sélectionner l'état d'entrée du bloc aval.

3. Circuit de traitement numérique selon l'une des revendications 1 ou 2, caractérisé en ce que chacun des registres de test (4, 5) est relié aux lignes de contrôle, d'adresse et de données de bus (6).

4. Circuit de traitement numérique selon l'une quelconque des revendications 1 à 3, caractérisé en ce que, à l'état de repos, les registres de test (4, 5) sont transparents.

5. Circuit de traitement numérique selon l'un quelconque des revendications 1 à 4, caractérisé en ce que, avant le début d'un cycle de lecture ou d'écriture, le bus de données est haute impédance.

6. Circuit de traitement numérique selon l'une quelconque des revendications 1 à 5, caractérisé en ce qu'il est compris dans une unité de décodage d'un flux de données représentant des images conformément à la norme MPEG.

7. Circuit de traitement numérique selon l'une quelconque des revendications 1 à 6, caractérisé en ce qu'un registre de test donné (4, 5) peut conserver l'état actif indéfiniment, tout en autorisant l'accès aux autres registres de test.

8. Circuit de traitement numérique selon l'une quelconque des revendications 1 à 7, caractérisé en ce qu'un registre de test (4, 5) au moins contient lui-même l'information de son état (actif ou repos).

9. Circuit de traitement numérique selon l'une quelconque des revendications 1 à 8, caractérisé en ce qu'un registre de test (4, 5) peut être activé par un programme dans l'environnement applicatif, tout en préservant le comportement normal des blocs du circuit non concernés.

## Patentansprüche

1. Digitale Verarbeitungsschaltung (9) mit einem Host-Interface (7), das den Zugriff seines Busses (6) auf ein externes Datenverarbeitungssystem (8) ermöglicht, wobei der Bus (6) Steuerleitungen, Adressenleitungen und Datenleitungen aufweist, die Schaltung aus Blöcken (1, 2, 3) und jeweils zwischen einem vorderen und einem hinteren Block angeordneten Prüfregistern (4, 5) besteht, wobei jedes Prüfregister (3, 4) mit dem Bus (6) verbunden ist, einen aktiven Zustand und einen inaktiven Zustand aufweist, durch eine Adresse identifiziert ist, was es ermöglicht ihm Daten zuzuführen oder die in ihm enthaltenen Daten zu lesen, und die Schaltung Einrichtungen aufweist, die das Erzeugen von Lese- oder Schreibsignalen in Abhängigkeit von den auf diesen Leitungen vorhandenen Signalen, welche sie in den aktiven Zustand überführen, ermöglichen, und komplementäre Einrichtungen aufweist, die das Schreiben oder das Lesen freigeben, und wobei der Zugriff auf jedes der Prüfregister unabhängig von den anderen Prüfregistern ist, dadurch gekennzeichnet, daß jedes Prüfregister einen von dem Schreibsignal gesteuerten ersten Multiplexer (43) aufweist, der die auf dem Bus transportierten Daten an einem seiner Eingänge empfängt und dessen Ausgang mit einem zweiten Multiplexer (42) verbunden ist, der von dem Ausgangssignal eines Operators (41) gesteuert ist, oder am Eingang das Schreibsignal und ein Schreibfreigabesignal empfängt, wobei der zweite Eingang mit dem vorderen Block und der Ausgang mit dem hinteren Block verbunden ist, daß jedes Prüfregister (4, 5) ein zwischen den Blöcken (1, 2, 3) angeordnetes D-Flipflop (45) aufweist, wobei die Blöcke durch das Register getrennt sind, wenn dieses den inaktiven Zustand innehat, und daß die Verarbeitungsschaltung Tests mit der nominellen Betriebsgeschwindigkeit eines Blocks n ermöglicht, wobei der Eingangstest in das vordere Register mit der Anstiegsflanke eines ersten Taktsignalimpulses eingeschrieben wird und das Lesen des hinteren Registers mit der Anstiegsflanke eines zweiten Taktsignalimpulses erfolgt, der dem ersten unmittelbar folgt.

2. Digitale Verarbeitungsschaltung nach Anspruch 1, dadurch gekennzeichnet, daß jedes Prüfregister das Betrachten des Ausgangszustands des vorderen Blocks und das Auswählen des Eingangszustands des hinteren Blocks ermöglicht.

3. Digitale Verarbeitungsschaltung nach einem der Ansprüche 1 oder 2, dadurch gekennzeichnet, daß jedes Prüfregister (4, 5) mit den Steuerleitungen, den Adressenleitungen und den Datenleitungen des Busses (6) verbunden ist.

4. Digitale Verarbeitungsschaltung nach einem der Ansprüche 1 bis 3, dadurch gekennzeichnet, daß die Prüfregister (4, 5) im inaktiven Zustand transparent sind.

5. Digitale Verarbeitungsschaltung nach einem der Ansprüche 1 bis 4, dadurch gekennzeichnet, daß der Datenbus vor dem Beginn eines Lese- oder Schreibzyklus eine hohe Impedanz aufweist.

6. Digitale Verarbeitungsschaltung nach einem der Ansprüche 1 bis 5, dadurch gekennzeichnet, daß sie in einer Einheit zum Dekodieren eines Datenstroms enthalten ist, welcher Bilder entsprechend der MPEG-Norm repräsentiert.

7. Digitale Verarbeitungsschaltung nach einem der Ansprüche 1 bis 6, dadurch gekennzeichnet, daß ein vorgegebenes Prüfregister (4, 5) den aktiven Zustand unbegrenzt beibehalten kann, wobei es gleichzeitig den Zugriff auf alle anderen Prüfregister freigibt.

8. Digitale Verarbeitungsschaltung nach einem der Ansprüche 1 bis 7, dadurch gekennzeichnet, daß wenigstens ein Prüfregister (4, 5) selbst Informationen über seinen Zustand (aktiv oder inaktiv) enthält.

9. Digitale Verarbeitungsschaltung nach einem der Ansprüche 1 bis 8, dadurch gekennzeichnet, daß ein Prüfregister (4, 5) durch ein Programm der Anwendungsumgebung aktivierbar ist, wobei das normale Verhalten der nicht betroffenen Blöcke der Schaltung gewahrt bleibt.

## Claims

1. Digital processing circuit (9) comprising a host interface (7) providing access from its bus (6) to an external data processing system (8), said bus (6) comprising control lines, address lines and data lines, said processing circuit being broken down into blocks (1, 2, 3) and having test registers (4, 5) interposed between an upstream block and a downstream block, each of the test registers (4, 5) being connected to the bus (6), having an active state and a rest state, being identified by an address allowing data to be sent to it or the data that it contains to be read, and comprising means allowing the generation of read or write signals according to the signals present on these lines and making said digital processing circuit pass to the active state, and additional means authorizing this write or read operation, and the access to each of the test registers being independent of the other test registers,
characterized in that each of the test registers comprises a first multiplexer (43) commanded by the write signal, one input of which receives the data flowing across the bus, the output of said first multiplexer being connected to a second multiplexer (42) commanded by the output of a logic operator (41) or receiving on input the write signal, and a write authorization signal, the second input of said second multiplexer being connected to the upstream block and the output of said second multiplexer to the downstream block, in that each test register(4, 5) comprises a D-type flip-flop (45) placed between the blocks (1, 2, 3), said blocks being separated by the register when it is in the rest state and in that the processing circuit allows operating tests to be conducted on a block n at nominal operating speed, the input test being written into the upstream register on the positive-going transition of a first clock pulse and read from the downstream register on the positive-going transition of a second clock pulse immediately following the first.

2. Digital processing circuit according to claim 1, characterized in that each test register allows to observe the output state of the upstream block and to select the input state of the downstream block.

3. Digital processing circuit according to any of claims 1 or 2, characterized in that each of the test registers (4, 5) is connected to the control, address and data lines of the bus (6).

4. The digital processing circuit according to any of claims 1 to 3, characterized in that the test registers (4,5) are transparent in the rest state.

5. The digital processing circuit of any one of claims 1 to 4, characterized in that the impedance of the data bus is high before the start of a read or write cycle.

6. The digital processing circuit of any of claims 1 to 5, characterized in that it is included in a unit for decoding a bit stream representing pictures complying with the MPEG Standard.

7. The digital processing circuit of any one of claims 1 to 6, characterized in that a given test register (4, 5) can maintain the active state indefinitely, while at the same time authorizing access to the other test registers.

8. The digital processing circuit of any one of claims 1 to 7, characterized in that at least one of test register (4, 5) contains its own state information (active or at rest).

9. The digital processing circuit of any one of claims 1 to 8, characterized in that a test register (4, 5) can be activated by a program in that application environment, while all the other blocks in the circuit that are not concerned continue to behave normally.
